# EUROPEAN PATENT SPECIFICATION

(11) **EP 1 847 843 B1**
(45) Date of publication and mention of the grant of the patent: **10.06.2009**
(21) Application number: 06112941.7
(22) Date of filing: 21.04.2006
(51) Int. Cl.: G01R 31/319, G01R 13/34

(54) **Digital data sampling by applying a plurality of time delayed trigger signals**
Digitale Datenabtastung unter Anwendung mehrerer zeitverschobener Auslösersignale
Echantillonnage des données numériques en appliquant une pluralité de signaux de déclenchement retardés

(43) Date of publication of application: 24.10.2007
(73) Proprietor: Agilent Technologies, Inc., Santa Clara, CA 95051 (US)
(72) Inventor: Moll, Joachim, 71083 Herrenberg (DE)
(74) Representative: Barth, Daniel Mathias

(56) References cited:
- EP-A2- 0 250 682
- US-A- 3 524 993
- US-A- 5 235 270
- US-A- 2004 236 527
- US-A1- 2005 225 310

## Description

### BACKGROUND ART

The present invention relates to sampling a digital data signal.

Characterizing the transient behavior of high-speed digital circuits, i.e. the transition from a logical zero to a logical one and vice versa, has become increasingly important for designing as well as manufacturing such digital circuits. Timing problems can cause single transmission errors, or temporary or even permanent outage of an entire communication system, and have to be avoided.

A standard characterization of digital circuits is the so-called Bit Error Ratio (BER), i.e. the ratio of erroneous bits to the total number of regarded bits. A received digital data signal is repetitively sampled at defined sample points. Each sampling point is determined at a threshold value for comparing a response signal with an expected signal, and at a relative timing (e.g. with respect to a corresponding transition of a clock signal - usually the system clock for generating the stimulus signals or a clock signal derived therefrom or from the response signal).

A further technique of determining the characteristic of digital data signals is real time sampling or equivalent sampling of such signals by so-called sampling oscilloscopes. Thereby, samples are targeted at specific time delays with respect to a trigger signal. In order to determine the position of an edge within the signal, the signal value at such targeted time is determined and the position of the edge is determined by fitting the signal value to a predefined or acquired edge model. Such measurements can be determined by appropriate digital oscilloscopes, such as the Agilent 86100 Series digital sampling oscilloscopes provided by the applicant Agilent Technologies. The Agilent 86100 Series oscilloscopes is capable for sampling high speed digital data signals having edges with rise and fall times below 20 picoseconds.

US 3,524,993 A discloses triggering method and apparatus, wherein the triggering period is determined. An oscilloscope having advanced triggering capability is known from US 2005/02253110 A1. EP 0250682 A2 describes a pulse measurement circuit. US 2004/0236527 discloses a first and a second trigger event, established by the user, for acquiring a first and a second set of data.

### DISCLOSURE OF THE INVENTION

It is an object of the invention to provide an improved sampling of a digital data signal. The object is solved by the independent claims. Preferred embodiments are shown by the dependent claims.

According to embodiments of the present invention, a signal analyzer is provided for determining a digital edge or transition timing of a digital data signal, the digital data signal comprising a sequence of a plurality of bits. The data signal might be provided by a device under test -DUT- that is to be tested according to specifications. Signal edges in high speed digital signals show significant durations of transition. The knowledge of an edge shape allows for sampling the signal once in such transition area and fitting the sampled value to the known edge shape in order to exactly timely locate the edge. Incorporating such analyzer into an under-sampling oscilloscope (i.e. into an oscilloscope having a sampling below the data rate of the sampled signals) allows exactly determining timings of signal edges.

The analyzer keeps stored, produces or accesses one or more edge models (e.g. one edge model, in case the rising edge and the inverted falling edge are similar; a rising edge model and a falling edge model otherwise, or multiple edge models for different bit histories) for characterizing signal transitions between the digital magnitude levels (low level and high level) of the data signal. The edge model describes the expected signal value over the time of the data signal. When fitting the edge model to the detected signal value, the difference in magnitude between said detected signal value and a timing reference value or predefined edge value is transformed into a time difference value. The predefined edge value might e.g. represent the edge center magnitudes at a 50% magnitude level between the low level and the high level or the mid-time between the beginning of the edge and the end of the edge, By relating the time difference value to the trigger signal, the exact position of the signal edge can be determined.

The edge model might be determined as a polynomial best fit curve of a measured signal edge. The edge model might be represented as section-wise curve composed of one or more linear or polynomial sections. Thereby, the edge model might be stored as mathematical formula or algorithm producing a time value out of an signal value, a table comprising a plurality of pairs of curve values and time values of said edge model, or as any mixture between algorithms and data.

A limitation of the above method is that corresponding trigger time points must be chosen to trigger the signal with the transition areas; otherwise it might not be possible to perform a value fitting to the stored modes; thus the trigger or measurement time range is limited to the time width of the transition.

According to an embodiment of the invention, an extended measurement (time) range is provided by placing a plurality of trigger signals at a defined distance to each other. The distance is preferably chosen to be equal to a measurement range of a single transition. Then, the extended measurement shows a corresponding extended width with respect to the width of the transition range (e.g. multiplied by the number of trigger signals).

In a further embodiment, a sampling circuit is provided comprising a plurality of sampling paths, each comprising a sample&hold circuit and an analog-to-digital converter. A data signal to be sampled is provided to each one sample&hold circuit. Further, a trigger control circuit is provided for generating a plurality of subsequent trigger signals in response to a clock signal. The trigger signals are provided to the trigger inputs of the sample&hold circuits. The outputs of the sample&hold circuits are connected to each one of the analog-to-digital converters. The corresponding digital values generated by the analog-to-digital converters are provided to an analyzing circuit that might chose the most significant value (i.e. the value not close or equal to the "low" or "high" signal level) for further edge fitting.

In a further embodiment the trigger pulses are generated relative to the clock signal. Thereby, the clock signal might be received separately from the data signal from the data source. Alternatively, the clock signal might be recovered from the data signal by means of a clock recovery circuit. Further alternatively, the clock signal might be derived from an internal clock having a defined frequency relation with respect to the data rate of the data signal.

In a further embodiment, the first most significant sample value is determined as value that shows a minimum magnitude distance to the defined transition value, preferably the mid point between a low level and a high level of the data signal.

In a further embodiment, the time delay is determined on the base of a transition duration of the first data signal, e.g. being equal to the transition duration. Thereby, the time delay might be chosen to be equal a measurement range, whereby the measurement range is defined as time interval between a first magnitude value greater than a low level of the data signal and a second value less than the high level of the data signal of the signal amplitude.

In a further embodiment, the determination of the signal edge time is repeated for a plurality of edges within the data signal, and jitter characteristics are determined on the base of variations of said edge times with respect to the signal clock or of variations of values based upon the edge times. If only measurements of time intervals having the same bit history, e.g. of edges at each the same position within the repeated bit pattern are performed, such mean value difference denotes the jitter components excluding data dependent jitter.

In a further embodiment, the data signal is analyzed with respect to a depth of influence of previous bits to an actual transition, or in other words with respect to the influence of the bit history. This influence can be denoted as number of preceding bits to an edge.

Therefore, the signal analyzer further comprises a digital sampling circuit additionally to the (analog) sampling circuit described above. The analog sampling circuit samples, at first trigger points, analog values of the data signal, preferably in a transition region, converts this values into (multi-bit) digital values and provides these first values to an analyzing circuit. The digital sampling circuit samples the data signal, preferably in the bit center region, i.e. in the center of the data eye of the data signal, i.e. in a region between signal transitions, at a plurality of subsequent second trigger time points, reproduces a bit sequence of the data signal, and provides these second values to the analyzing circuit. Thereby, the bit sequence of the data signal might be determined by comparing the data signal with a threshold, assigning one of two bit values depending on the comparison result (e.g. a "0" value, if the comparison result is negative and a "1" value if the comparison result is positive) at successive second trigger points.

The sequences of a defined number of digital values provided by the digital sampling circuit are collected with respect to the edges to be analyzed, i.e. each first (multi-bit) sample value is assigned to a certain sequence of second sample (single bit values), also being referred to as bit history.

In order to determine a number of preceding subsequent bits influencing an actual transition, i.e. to determine a depth of influence of previous bits to an actual transition, sampled values of repetitive measurements are sorted or binned according to their bit history, e.g. binned to eight different groups each related to one history of a three bit sequence. Such binning is further extended to longer history as long as they show different mean values with respect to the clock signal.

In a further embodiment, a signal analysis is carried out for determining data-independent jitter characteristic by generating trigger signals on the condition that a defined history, i.e. a defined bit sequence of the data signal is being detected.

If the influence is found to be limited to a number of n bits, a determination of jitter excluding data depending jitter might be carried out by detecting a certain sequence n bits and triggering on each occurrence of this pattern. This is in particular advantageous, if long bit sequences are used, where an analysis of every edge position would take too long.

Alternatively, the sampling might be performed at random timing points, whereby the first sample values (representing the actual edge value) and the second sample values (representing the bits of the data signal) are stored with relation to each other. In a post processing the first sample values are sorted with respect to a certain number of preceding bits into different bins.

In a further embodiment, a time interval analysis is provided, whereby each signal edge of said time interval is sampled with an extended measurement range. By, way of example, for duplicating the measurement range, four corresponding trigger signals are provided to corresponding two sample&hold circuits The third trigger pulse and a fourth trigger pulse thereby are generated being delayed to each other by the defined time delay, wherein the third trigger pulse is being delayed with respect to the first trigger pulse by one or a plurality of bit periods of the data signal. The analyzing circuit receiving four corresponding sample values (multi-bit digital values) for the two edges selects for each edge one value to be further processed.

From the selected values, a first time difference and a second time difference between the might be determined. A time interval analysis is then provided on the base of the second time difference and the first time difference, e.g. by taking the difference between the trigger times of the first and second most significant sample values, and a time difference between the second time difference and the first time difference.

In a further embodiment the analog sampling circuit comprises a sample&hold circuit, and an analog-to-digital converter. The sample&hold circuit receives first trigger signals and provides each an analog value (e.g. an analog voltage) of the data signal at a corresponding first trigger times and keeps this values each stored for a certain amount of time. The analog-to digital converter converts the received analog value into a multi bit digital value, e.g. being represented as 12 bit data or 16 bit data.

In a further embodiment, the analyzing circuit comprises a processing unit for storing the one or more edge models in terms of digital values, e.g. arranged in tables of time/signal value pairs, or in terms of an algorithm providing digital values. Therewith, the above-described time differences are determined by a digital calculation of the computer. Such models and algorithms might be stored in for of software programs.

Alternatively, the sample&hold circuits of the above embodiments might be replaced by so-called track&hold circuits.

Embodiments of the invention can be partly or entirely embodied or supported by one or more suitable software programs, which can be stored on or otherwise provided by any kind of data carrier, and which might be executed in or by any suitable data processing unit.

### BRIEF DESCRIPTION OF DRAWINGS

Other objects and many of the attendant advantages of embodiments of the present invention will be readily appreciated and become better understood by reference to the following more detailed description of embodiments in connection with the accompanied drawing(s). Features that are substantially or functionally equal or similar will be referred to by the same reference sign(s).

Fig.1a shows a schematic block diagram of a sampling device with an enhanced measurement range according to a further embodiment of the invention,

Fig.1b shows a variant of Fig.1a with a sampling comprising a first sample&hold circuit and further two sample&hold circuits connected to the first sample&hold circuit,

Fig.1c shows an exemplary sampling diagram pertaining to Fig.1a,

Fig. 2a shows a diagram with a fraction of an first exemplary data signal over the time with exemplary time measurement values relating to a time interval between two adjacent signal edges,

Fig. 2b shows a diagram with fraction of a second exemplary data signal over the time with exemplary time measurement values between signal edges at a distant of a plurality of clock cycles,

Fig. 2c shows a schematic diagram with a distribution of rising edge times and falling edge times of repeated measurements at each one bit with the same bit history,

Fig. 2d shows a schematic diagram with a distribution of resulting cycle times of the measurement of Fig.2c,

Fig.3 shows a schematic block diagram of a sampling device comprising a digital sampling path and an analog sampling path according to a further embodiment of the invention,

Fig.4 shows a tree diagram with different hierarchies of bit history to a rising edge being collected in different bins and exemplary time distributions of different bins,

Fig. 5 shows a block diagram of a time interval analyzer comprising a digital sampling path and an analog sampling path according to Fig. 3, and

Fig.6 .shows schematic diagrams describing a jitter separation with bit history consideration.

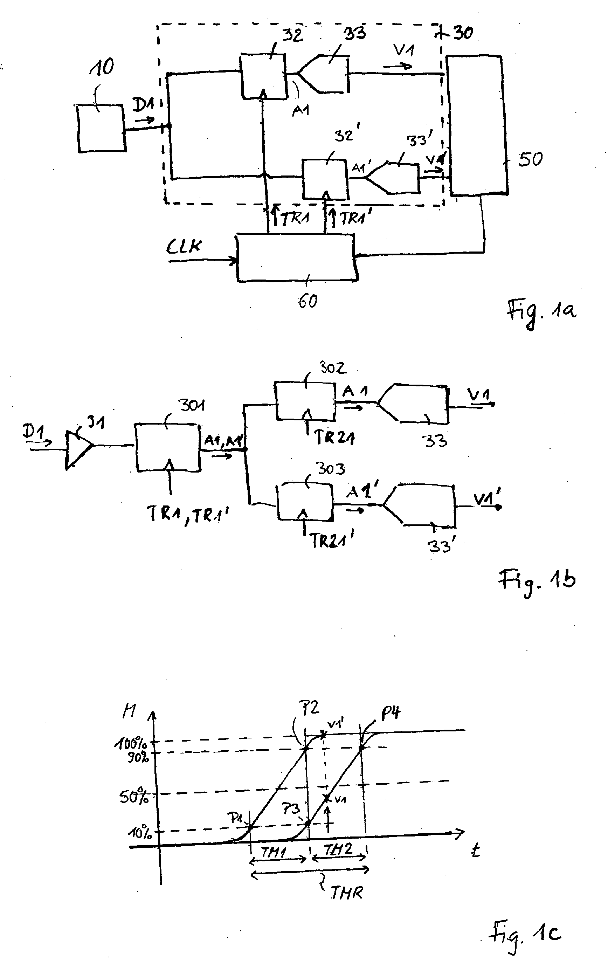

Fig.1a shows a block diagram of a signal analyzer with an enhanced measurement range. By way of example, the signal analyzer shows an analog sampling circuit 30 comprising a first and a second sample&hold circuit 32 and 32' and a first and second analog-to digital converter 33 and 33', whereby the outputs of the first and second sample&hold circuits 32 and 32' are each connected to the inputs of the analog-to digital converter 33 and 33' respectively. The outputs of the analog-to digital converters 33 and 33' are connected to a signal analyzing circuit 50.

A (digital) data signal D1 is provided to the data inputs of the sample&hold circuits 32 and 32' sampling actual data signal values A1 and A1' at the time points of receiving a first trigger pulse TR1 and a second trigger pulse TR1' respectively. These analog values, which might be represented as analog voltages within a certain voltage range, are held for a certain (short) period of time. Within this period of time these values are provided to the analog-to digital converters 33 and 33' converting the received analog values into multi-bit digital values V1, V1', e.g. being represented as 12 bit data or 16 bit data. Such digital data values are provided to the analyzing circuit 50 for further processing as described in the following.

Further, a trigger circuit 60 is provided that receives a clock signal CLK from a source, e.g. from the DUT 10 or any clock having either the same frequency as the DUT or any frequency related to the data signal D1. The trigger circuit 60 provides a first trigger pulse TR1 to the trigger input of the first sample&hold circuit 32 and a second trigger pulse TR1' (being delayed with respect to the first trigger pulse TR1) to the trigger input of the second sample&hold circuit 32'. Not shown here, the trigger circuit further provides a corresponding converter trigger signal to the analog-to-digital converters 33 and 33'.

The data signal D1 is provided (e.g. over an input buffer not shown here) in parallel to the inputs of both the first and second sample&hold circuits 32 and 32', which sample the actual data signal values A1 and A1' at the time points when receiving the first trigger pulse TR1 and the second trigger pulse TR1' respectively, whereby the time distance between both trigger signals TR1 and TR2 is determined to be equal or shorter than the transition duration. The analog-to digital converters 33 and 33'convert the received analog values A1 and A1' into digital value V1 and V1'. This digital data values are provided to the analyzing circuit 50 for further edge fitting.

The analyzing circuit 50 keeps stored one or a plurality of edge models for characterizing a signal edge, e.g. rising edge or a falling edge between the digital magnitude levels of the data signal. The edge model describes the expected signal value over the time of the data signal D1. For fitting said edge model to the detected signal value, the difference in magnitude between said detected signal value and predefined signal value is transformed into a first time difference value Δt1. By way of example, the predefined signal value is the center values at a 50% level between the "low" bit signal level and a "high" bit signal level. By relating the time difference value to a reference, the exact position of the signal edge can be determined.

The edge models might be stored in form of a plurality of (multi-bit) digital data (e.g. 12 bit data or 16 bit data) with a certain time resolution. Alternatively, the edge model can be stored e.g. as polynomial best fit curve of a most likely edge or a (time or magnitude) section-wise curve composed of one or more linear or polynomial sections. The data might be stored in a memory or data base being part of or being accessible by the time interval analyzer.

The analyzing circuit 50 selects one of the received digital values V1 and V1' and performs an edge time determination by fitting the selected digital value V1 or V1' to an edge model, thereby transforming a difference in magnitude between said detected signal value and a predefined signal value into a time difference values as described above.

Fig.1b shows a variant of Fig.1a with a sampling circuit comprising a fast sample&hold circuit 301 being arranged to receive the first trigger pulse TR1 and the second trigger pulse TR1' at its trigger input and to receive the data signal D1 at its signal input. The sampling circuit of Fig.1b exemplarily shows a first and second slow sample&hold circuit 302 and 303, each receiving at their signal inputs the signal output from the fast sample&hold circuit 301 The trigger circuit 60 alternately provides trigger pulses TR21 andTR21' to each one of the trigger inputs of said slow sample&hold circuits 302 and303.

The high bandwidth first sample&hold circuit 301 allows for precise sampling with little signal deterioration. However, such high bandwidth sample&hold circuit may have short hold times. In this embodiment, only one sample&hold circuit needs to have highest bandwidth, whereas slow sample&hold circuits 302 and 303 might show lower bandwidths, and can be optimized for longer hold times. As a further advantage, the input signal has a smaller load impact compared to the above embodiment.

The trigger circuit 60 generates the trigger pulses TR1 and TR1' with respect to the clock signal CLK at a defined distance to each other. The distance is preferably chosen to be equal to a measurement or trigger time range of a single transition. Fig.1c shows an example, wherein two signal edges are depicted at the trigger time distance TR1'-TR1. This time distance is chosen to be equal to the measurement range TM1 or TM2 of the transition. In the example shown here, the measurement range is chosen as time interval between each a 10% point P1 of the signal amplitude (i.e. the difference between the high level and the low level) and a 90% point P2 of the signal amplitude, or between corresponding points P3 and P4 of the delayed transition correspondingly. This allows for multiplying the resulting measurement range TMR by two. Providing further additional sample&hold circuits connected in parallel to the first and the second sample&hold circuit 32 and 32' allows for extending the resulting measurement range corresponding to the number of the sample&hold circuits.

As consequence, there will be only one value out of the values V1 or V1' that can be used for edge fitting, whereby the other value will have the high level value or low level value or a value close to these values. In the example shown here, the first sample&hold circuit 32 derives a sample value V1 of roughly 40% of the signal amplitude, whereas the value V1' derived from the delayed measurement by the second sample&hold circuit 32' shows almost the maximum level. Whereas the first value V1 can be well used for an edge fitting, the value V1' can hardly be used for an edge fitting. Therefore, before the edge fitting, the analyzing circuit might chose the most significant value (i.e. the value that is not close or equal to the low or high signal level or the value that refers to the higher absolute gradient of the signal edge).

Alternatively, the signal analyzer might comprise a first and a second sampling path each comprising one sample&hold circuit and one switchable transfer gate. The transfer gates are alternately triggered in order to alternately provide the first sampled value and the second sampled value to one single analog-to-digital converter. Similar to the previous embodiment, the analyzing circuit receives the analog values V1 and V1' for further processing.

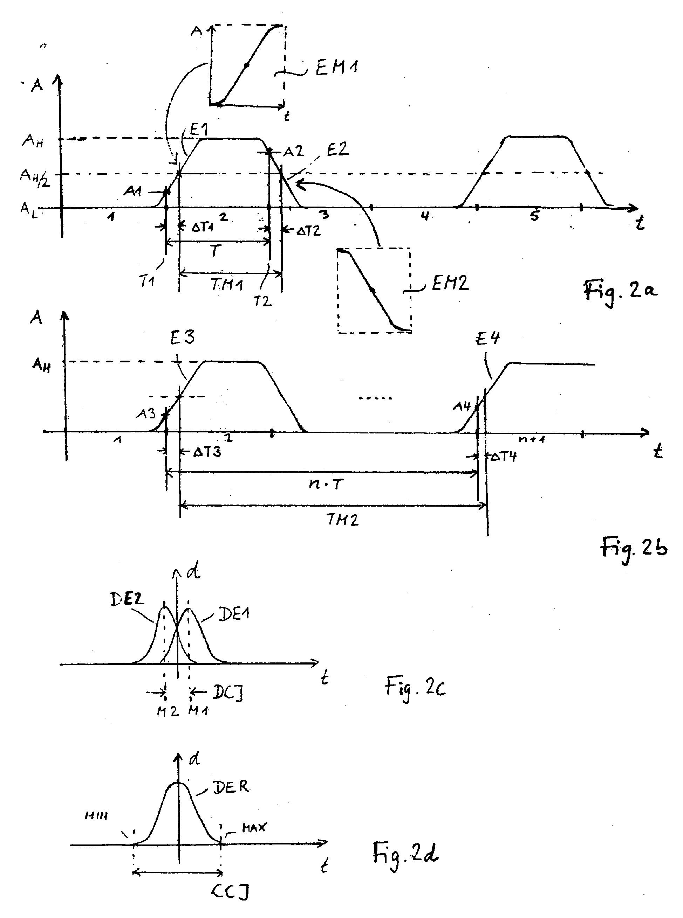

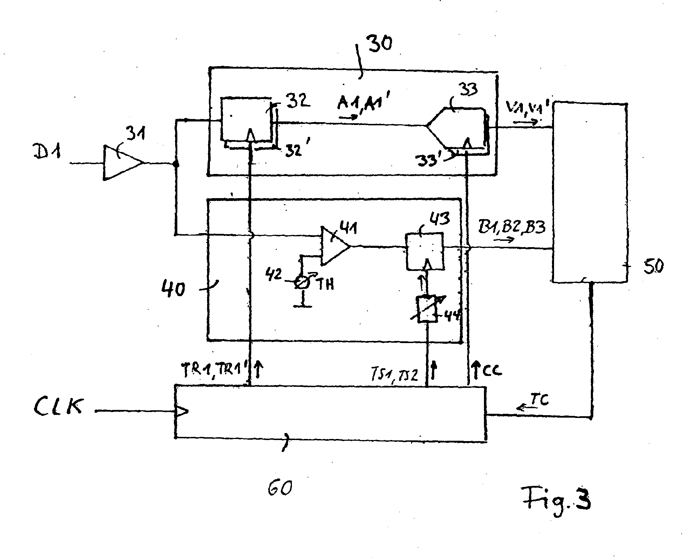

Before explaining Figs. 2, Figs. 3 and 4 shall first be illustrated. Fig. 3 shows a block diagram of a signal analyzer comprising the analog sampling circuit or path 30 as described above and a digital sampling path 40. The input data signal D1 is provided, over an input buffer 31, to the analog sampling path 30 and the digital sampling path 40. The analog sampling path 30 provides the sampled transition values V1 and V1' to a first input of a signal analyzing circuit 50. Further, the trigger circuit 60 is provided that receives the clock signal CLK from a source not shown here, e.g. provided by a data source providing a digital data signal D1 recovered from the data signal D1 or being generated by an independent clock and a control signal TC from the analyzing circuit 50. The trigger circuit 60 provides a first trigger signal comprising the first and second trigger pulses TR1 and TR1' to the trigger inputs of the sample&hold circuits 32 and 32', and further provides a corresponding converter control signal CC to the analog-to-digital converters 33 and 33', whereby the time distance between the trigger pulses of this control signal is selected according to capabilities of holding a captured value over time of the sample&hold circuits.

Further, the digital sampling path 40, also being referred to as bit history determination path, is provided for taking a plurality of second sample values from the data signal D1 at a plurality of subsequent digital path trigger time points TS1, TS2, whereby these trigger points are preferably placed at equidistant time points within each the bit center of the data signal, i.e. these trigger points being placed in the center of the data eye.

The analyzing circuit further comprises a comparator 41, a tunable threshold voltage source 42, a sampling flip flop (or digital sample&hold circuit) 43, and a tunable time delay circuit 44. A first input of the comparator 41 is connected to the buffer 31 for receiving the (buffered) data signal D1, whereas a second input of the comparator 41 is connected to the tunable threshold voltage source 42 that provides a tunable threshold voltage TH to said input. The output of the comparator 41 is connected to the data input of the sampling flip flop 43. The output of the sampling flip flop 43 is provided to the data analyzing circuit 50. The trigger input of said sampling flip flop 43 is connected to the tunable time delay circuit 44 that receives the clock signal CLK and provides a correspondingly delayed clock signal to the trigger input of the sampling flip flop 43. The clock signal CLK is preferably delayed such that the digital path trigger points are placed in the center of the data eye of the digital data signal D1.

The comparator 41 compares the digital data signal D1 with a constant threshold TH (e.g. the mean between the low signal level representing a bit value of "0" and the high signal level representing a bit value of "1", also being referred to as 50% level), or a dynamic threshold as e.g. applied in so-called decision feedback equalization (DFE). The comparator 41 generates a first value (e.g. a low voltage level), if the corresponding comparison value is below the threshold and a second value (e.g. a high voltage level"1", if the comparison value is above the threshold TH.

The sampling flip flop 43 samples the comparison result each at the digital path trigger points and assigns digital time discrete comparison results B1-B3 that are provided as bit stream to the analyzing circuit 50.

In one embodiment, the analyzing circuit 50 might continuously analyze the received bit stream B1, B2, B3 for detecting a predefined bit sequence within this bit stream. As soon as such predefined bit stream is detected, the analyzing circuit 50 generates feed-back information TC to the trigger circuit 60. The trigger circuit 60 then provides first trigger pulses TR1, TR1' at the next possible signal transition. The correspondingly derived pairs of multi-bit digital values V1, V1' all have the same defined bit history. If such values are collected a plurality of times and corresponding time delays are superimposed as e.g. described above under Fig.2c, data-independent jitter might be determined, provided that the length of the bit history is long enough to cover for history influences. The number of bits to be part of the bit history might be a fixed number or a selectable number being selected by the user.

Alternatively, the sampling might be performed at random timing points, whereby the first sample values (representing the actual edge value) and the second sample values (representing the bits of the data signal) are stored with relation to each other. In a post processing the first sample values are sorted with respect to a certain number of preceding bits into different bins.

In order to determine a number of preceding subsequent bits influencing an actual transition, i.e. to determine a depth of influence of previous bits to an actual transition, the analyzer is adapted for repetitively determining transition values V1 of all bit transitions or a subset of bit transitions of bit sequence of the data signal D1. At the same time the digital bit sequence B1, B2, B3 being received from the sample flip flop 43 is received and related to the transition values V1. The analyzing circuit 50 might then (in a post processing step) assign to each sample value V1 being sampled in the analog path a defined number of preceding bits B1, B2, B3, being sampled in the digital path.

Alternatively, if the bit sequence of the data signal D1 is known, or in other words, if the data signal D1 is known in principle, such sequence might be assigned to the sampled values V1 directly without digital sampling. In this case it might be sufficient to digitally sample at specific times in order to synchronize to the data signal D1.

Further alternatively, the sampled digital sequence might be used for synchronizing, i.e. for detecting a match of the sampled digital sequence with a sequence part of the known data signal D1, and performing a time relation with the analog sampling circuit. Therefore the analyzing circuit 50 might provide trigger control signals TC to the trigger circuit 60.

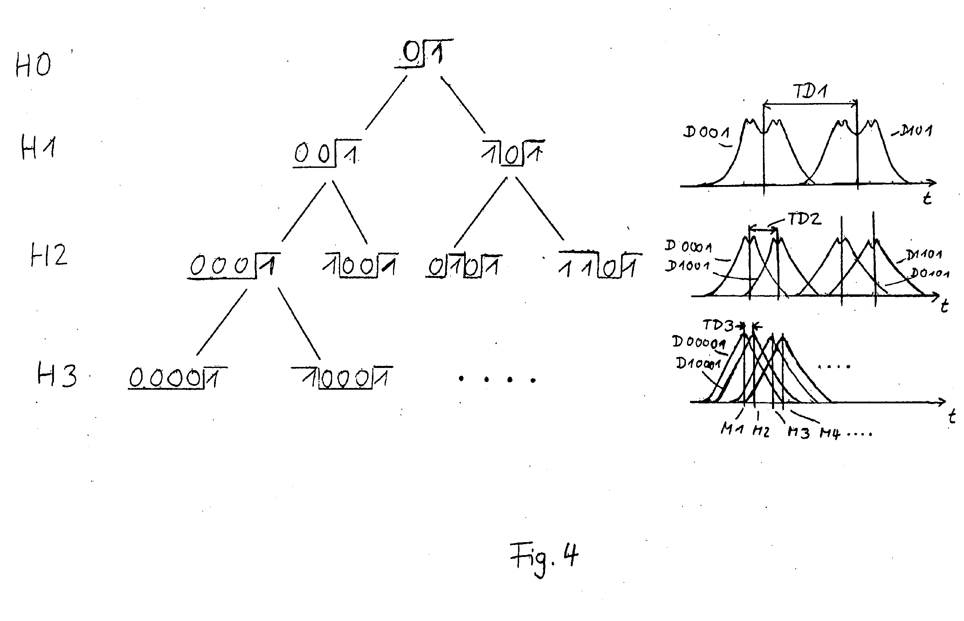

Fig.4 shows a schematic diagram for determining the number of bits being relevant as bit history. In the first row H0 on the left side, a bit sequence of two bits "01" showing a transition with a rising edge, i.e. a transition from "0" to "1" is shown. In the second row, also being referred to as first history level H1, on the left side, 2 bit sequences of three bits, "001" and "101" are shown. The first sequence "001" of this level equals the sequence "01" of the row above together with a preceding bit "0". The second sequence "101" of this level equals the sequence "01" of the row above together with a preceding bit "1". On the right side of this level, for each of these sequences, a distribution of edge times D001 and D101 with respect to a clock signal as result of a plurality on measurements is shown. The difference of the mean values of both distributions D001 and D101 is depicted as first time distance TD1. This time distance indicates the dependency of first preceding bit on the edge timing of the data signal D1.

In the third row, also being referred to as second history level H2, on the left side, 4 bit sequences of four bits, "0001", "1001", "0101" and "1101" are shown. The first sequence "0001" of this level equals the first sequence "001" of the row above together with a preceding bit "0". The second sequence "1001" of this level equals the sequence "001" of the row above together with a preceding bit "1". The third sequence "0101" of this level equals the second sequence "101" of the row above together with a preceding bit "0". The fourth sequence "1101" of this level equals the second sequence "101" of the row above together with a preceding bit "1". On the right side of this level, distributions D0001, D1001, D0101 and D1101 of the edge times for the four different histories with respect to a reference signal as result of a plurality on measurements are shown. The difference of the mean values of the distributions D0001 and D1001 is depicted as second time distance TD2. This time difference indicates the dependency of the second preceding bit on the edge timing of the data signal D1. As qualitatively depicted this time distance TD2 is smaller than the first time distance TD1. For completeness reason, it is mentioned that the same measurement of time difference might be carried out for the third and the fourth sequence.

In the fourth row, also being referred to as third history level H3, on the left side, exemplary 2 bit sequences out of 8 sequences comprising 5 bits, "00001", "10001" are shown. The first sequence "00001" of this level equals the first sequence "0001" of the row above together with a preceding bit "0". The second sequence "10001" of this level equals the first sequence "0001" of the row above together with a preceding bit "1". On the right side of this level, exemplary for the shown first two sequences of this row, the first four distributions D00001 D10001, D01001, and D11001, of the edge times for the corresponding histories with respect to a time reference as result of a plurality on measurements are shown. The difference of the mean values of both distributions is depicted as third time distance TD3. This time difference indicates the dependency of the third preceding bit on the edge timing of the data signal D1. As qualitatively depicted this time distance TD3 is smaller than the second time distance TD2. Again for completeness reason, it is mentioned that the same measurement of time difference might be carried out for the third and the fourth, the fifth and sixth, and the seventh and eighth sequence not shown here.

As result of the history separation of the fourth history level, mean edge times M1, M2, M3, M4,.., are obtained as mean values of the corresponding edge time distributions.

A simple algorithm for determining the depth of bit history might thus proceed as follows:

In a first measurement run, a certain number of transition measurements (e.g. 1024 samples) are performed. The corresponding timing results are sorted in separate bins in dependence on their bit history. On the first history level, the timing results are binned in dependence on the value of the first preceding bit. Therewith, the measured samples are sorted into two bins 001 and 101. For each bin, the mean values of the distributions are determined and the corresponding first time distance TD1 is compared with a predefined (sufficiently small) maximum time. If the first time distance TD1 does not exceed the predefined maximum time, the depth of influence is expected to be one bit. Otherwise, if the first time distance TD1 exceeds the predefined maximum time, the timing results are sorted into four bins 0001, 1001, 0101 and 1101 of the second history level H2. Again, the second time distance TD2 between two mean values (e.g. the mean values of the bins 0001, 1001) originating from one bin of the above level (e.g. bin 001), (and/or from the mean values of the bins 0101 and 1101) of this level is compared with the predefined maximum time. If the second time distance TD2 now does not exceed the predefined maximum time, the depth of influence is expected to be two bit. Otherwise this algorithm is continued in the same manner for further history levels.

Due to the limited number of measurement obtained the first run, the number of bins for sorting the measurement values is limited, because a sufficient number of results is necessary for obtaining relevant distributions for the corresponding edge timings. (E.g. for 1024 measurement values, the algorithm might stop at the third history level, wherein each bin will have 128 measurement values at average.) If the corresponding time difference is found to exceed the predefined maximum time at a certain history level (e.g. the third history level H2 for 1024 values), another set of measurements might be obtained in a second measurement run (e.g. again 1024 measurement values) in order to provide a sufficient number of values for further sorting. The second measurement run can be carried out in parallel to the (post-processing) history level evaluation algorithm.

As described above, the trigger time points must be chosen such that the signal is sampled within its transition areas. In order to further enhance the corresponding trigger time range, a filter showing a linear phase response might be connected between a data input and a corresponding sampling circuit. This filter decreases the (absolute) gradient of the signal edges without influencing further timing characteristics, e.g. the jitter properties, of the data signal.

In an embodiment, a time interval analyzer is provided for determining time interval characteristics of intervals between signal edges of the data signal D1. The control circuit 60 of previous embodiments therefore is adapted for further generating a third trigger pulse and a fourth trigger pulse, wherein the third trigger pulse and a fourth trigger pulse are being delayed by the defined time delay, and wherein the third trigger pulse is being delayed with respect to the first trigger pulse TR1 by one or a plurality of bit periods T, nT of the data signal D1. Further, the analog sampling path 30 is adapted for further taking a third sample value and a fourth sample value from said data signal D1 (or a related data signal) in response to the third trigger pulse and the fourth trigger pulse. The analyzing circuit 50 is further adapted for determining a second most significant sample value out of the third sample value and the fourth sample value, determining from said edge model a second time difference Δt2 between the second most significant sample value and a defined transition value and providing a time interval analysis on the base of the second time difference Δt2 and the first time difference Δt1.

For determining a time interval between two signal edges, for each edge, the time distance between the corresponding time points of the fitted detected signal value and of the predefined transition value is determined. From the time difference values determined for two edges of a signal interval and a known position of the trigger pulses, the analysing circuit 50 might determine a time interval. Further, a plurality of timing characteristics, e.g. signal jitter characteristics as described under Fig.2c - Fig.2d, can be derived.

Fig.2a shows a first diagram with the signal magnitude A of a non-return-to-zero (NRZ) data signal over the time t. The data signal exemplarily comprises a bit sequence "01001" within the bit cycles 1-5 (as depicted on the abscissa). By way of example the low signal level AL representing a "0" bit equals zero. Accordingly, the 50% level between said low signal level AL and the high signal level AH representing a "1" equals AH/2.

Exemplarily, a first time interval TM1 between a rising signal edge E1 and a falling signal edge E2 of the second bit is determined. The data signal is sampled at a first sample time T1 obtaining a corresponding first signal sample A1 and at a second sample time T2, obtaining a corresponding second signal value A2. These values are fitted to a rising edge model EM1 and a falling edge model EM2 respectively. The edge models EM1 and EM2 describe the edge characteristics of the data signal D1. From the difference in magnitude between the first sampled value A1 and a center value at the 50% signal level, and the second sampled value A2 and the center value at the 50% signal level, the time differences or deviations Δt1 and ΔT2 for each the rising edge and the falling edge are determined respectively. As the difference between the first sample time T1 and the second sample time T2 corresponds to the bit cycle time T, the time interval TM1 is obtained by subtracting the rising edge time deviation Δt1 from the cycle time T, and adding the falling edge time deviation ΔT2 thereto.

Fig.2b shows a variation of a measurement for a multi-cycle time interval TM2. The data signal exemplarily comprises a third rising edge E3 between the first and the second bit cycle and a fourth rising edge E4 between the n-th bit cycle and the (n+1)-th bit cycle. Corresponding to Fig.2a, third and forth time differences ΔT3 and ΔT4 for both rising edges are determined, and the difference between both edges is determined by subtracting the third time deviation ΔT3 from the n-cycle time nT and adding the fourth time difference ΔT4 thereto.

Fig. 2c shows a schematic diagram with a first distribution DE1 of all rising edge times and a second distribution DE2 of all falling edge times over the time t as result of repeated measurements at each one bit with the same bit history, e.g. at each the same position within the repeated test bit pattern or with a same history of a defined length as described above. The test bit pattern might be a pseudo random bit sequence of length 2¹⁵ -1 being repeated 1000 times. For both distribution DE1 and DE2, mean values M1 and M2 are determined. The difference between the mean values M1 and M2 denotes a so-called duty cycle distortion (DCD) of the data signal.

Fig. 2d shows a schematic diagram with a third distribution DER of a bit interval TM1 again as result of repeated measurements at each one bit with the same bit history. As the cycle time T is constant, the variation of the bit interval equals the variation of the difference between the time differences Δt1 and ΔT2. The difference between a maximum bit interval MAX and a minimum bit interval MIN denotes the peak-to-peak value of the cycle-to cycle jitter. If only bits with the same bit history are measured, this value does not comprise data dependent jitter DDJ, but random jitter and periodic jitter.

As alternative, all bit intervals of a repeated test sequence might be measured regardless the bit history. In this case, the difference between a maximum bit interval MAX and a minimum bit interval MIN denotes a peak-to-peak value of the cycle-to cycle overall jitter including data dependent jitter DDJ. The data dependent jitter DDJ might be determined by taking the difference between this measurement and the measurement above, wherein only bits with the same history are measured.

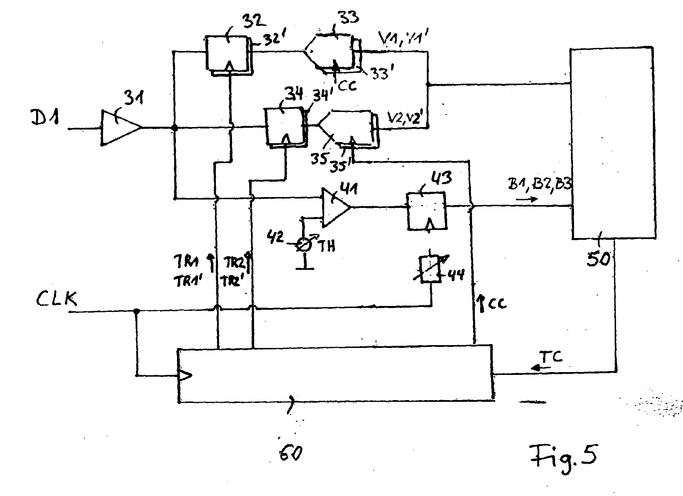

Fig. 5 shows a detailed block diagram of a time interval analyzer representing a synthesis of previous embodiments. The time interval analyzer comprises a modified analog sampling path and the digital sampling path with respect to the signal analyzer of Fig.3. The analog sampling circuit comprises two path, with the first path comprising the first and a second sample&hold circuit 32 and 33' with its outputs being connected to the input of first and second analog-to digital converters 33 and 33' and a second (duplicated) path comprising a third and a fourth sample&hold circuit 34 and 34' with its outputs being each being connected to each an input of a third and fourth analog-to digital converter 35 and 35'.

A trigger circuit 60 receiving the clock signal CLK provides a first trigger pulse TR1 and a second (delayed) trigger pulse TR1' to the first and second sample&hold circuit 32 and 32', a third trigger pulse TR2 and a fourth trigger pulse TR2' to the third and fourth sample&hold circuit 34 and 34', and a converter control signal CC to the analog-to-digital converters 33, 33', 35 and 35'.

As being described previously, the analog sampling might be performed at random timing points with respect to the data content of the data signal. The corresponding first sample values V1, V1', V2 and V2 and second sample values B1, B2, B3,..., are stored with relation to each other by the analyzing circuit 50. In a post processing, in a first step, the most significant sample values of each the values V1 and V1' and the values V2 and V2' are selected as described under Fig.1a.

In a second step, the selected first sample values or time distance values derived therefrom are sorted with respect to their bit history into different bins.

In order to derive non-data dependent jitter characteristics, only time difference values of one pairs of bins might be used for the time interval analysis.

In a further embodiment, the relevant number of history bits might be derived by means of an algorithm described under Fig.4.

The number of bits to be part of the transition history might be a fixed number or a selectable number being selected by the user or being automatically determined by the analyzer.

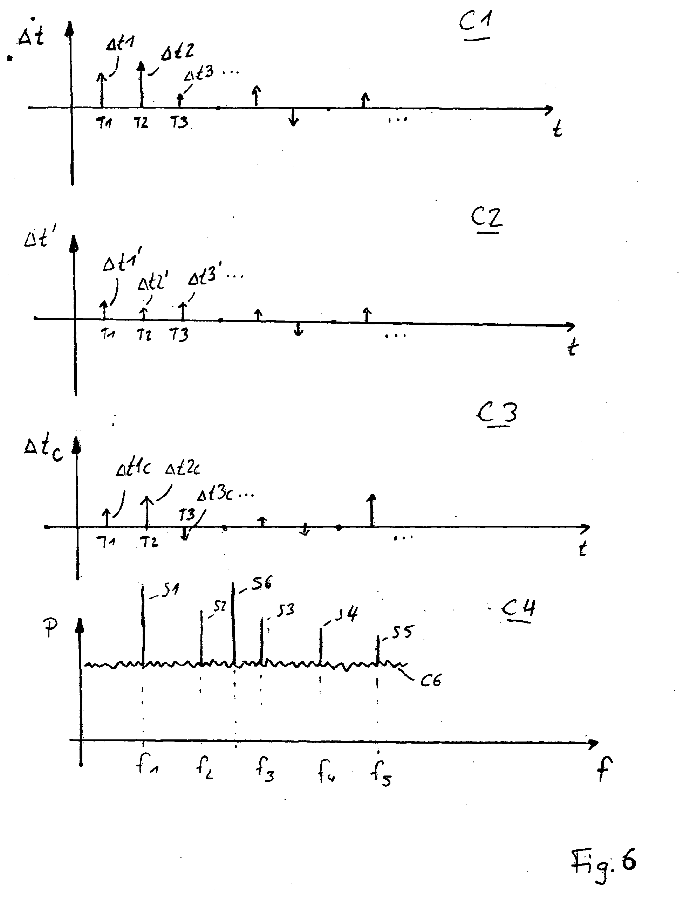

Fig. 6 shows schematic diagrams describing a jitter separation with bit history consideration that might be performed in signal analyzers of the figures shown above.

In a first diagram C1, time difference values Δt1, Δt2, Δt3 are obtained from sample values at subsequent time points T1, T2, T3 in transition areas of the data signal D1. The values are obtained for transitions with different bit histories. Therefore, a jitter analysis of these values will include data dependent jitter.

In a second diagram C2, mean time difference values Δt1', Δt2', Δt3' are depicted that relate to the mean time differences M1, M2, M3,..., (e.g. obtained by a measurement according to Fig. 4) related to the different bit histories of the sampled values.

In a third diagram C3, adjusted difference values Δt1c, Δt2c, Δt3c are depicted that result from taking the differences Δt1 - Δt1', Δt2- Δt2', Δt3- Δt3' between each the time differences values and the mean time difference values. A jitter analysis of these values will not comprise data dependent jitter, but still comprises random jitter and periodic jitter.

For further decomposition, a Discrete Fourier Transition, preferably a Fast Fourier Transformation of the adjusted time difference values Δt c, Δt2c, Δt3c might be performed, thereby obtaining a power density spectrum P over the frequency f. If periodic jitter is present, this spectrum will show one or more distinct frequency lines.

Providing a spectral jitter analysis the jitter components can be detected, e.g. the periodic jitter component can be derived by transforming the identified one or more distinct spectral components into the time domain.

C4 shows an exemplary of power density spectrum derived from a Discrete Fourier Transformation of the adjusted time difference values Δt1 c, Δt2c, Δt3c, thereby obtaining a power density spectrum P comprising by way of example peak frequencies S1- S6 referring to periodic jitter and roughly constant function over the frequency C6 referring to random jitter. By way of example, the frequency peaks S1- S5 are equidistantly spaced at exemplary frequencies f1- f5.

Instead of analyzing a single ended ground referenced signal D1, this signal might be received as a differential signal being transmitted over a differential line. The differential signal might de terminated by an input buffer that generates a ground referenced signal out of the differential signal. Alternatively, the input buffer, sample&hold circuit(s), and/or the analog-to-digital converter(s) of the above embodiments might be realized as differential signal circuits.

## Claims

1. A signal analyzer for determining timing characteristics of a data signal (D1) comprising a bit sequence of a plurality of bits, the signal analyzer comprising:
a control circuit (60) adapted for generating a first trigger pulse (TR1) and a second trigger pulse (TR1'), the second trigger pulse (TR1') being delayed with respect to the first trigger pulse (TR1) by a defined time delay,
a sampling circuit (30) adapted for taking a first sample value (A1) and a second sample value (A1') from the data signal (D1) in response to the first trigger pulse (TR1) and the second trigger pulse (TR1') respectively, and
**characterised by** further comprising:
an analyzing circuit (50) adapted for retrieving an edge model (EM1, EM2) describing an expected signal transition (E1, E2, E3, E4) of the data signal (D1) and being represented as signal magnitude over time within a bit transition region, determining a first most significant sample value out of the first sample value (A1) and the second sample value (A1') and determining from said edge model a first time difference (Δt1) between the most significant sample value (A1, A1') and a defined transition value.

2. The signal analyzer of claim 1, wherein the first most significant sample value (A1, A2) is determined as value that shows a minimum magnitude distance to the defined transition value, preferably the mid point between a low level and a high level of the data signal (D1).

3. The signal analyzer of claim 1 or 2, wherein the time delay is determined on the base of a transition duration of the data signal (D1).

4. The signal analyzer of any one of the above claims, wherein the control circuit (60) is adapted to determine the time delay to be equal to a measurement range (TM1, TM2) whereby the measurement range (TM1, TM2) is chosen as time interval between a first magnitude value (P1) greater than a low level of the data signal (D1) and a second value (P2) less than the high level of the data signal (D1) of the signal amplitude.

5. The signal analyzer of any one of the above claims, wherein the control circuit (60) is adapted for further generating a third trigger pulse and a fourth trigger pulse, wherein the third trigger pulse and a fourth trigger pulse are being delayed by the defined time delay, and wherein the third trigger pulse is being delayed with respect to the first trigger pulse (TR1) by one or a plurality of bit periods (T, nT) of the data signal (D1).

6. The signal analyzer of the preceding claim, wherein the sampling circuit (30) is adapted for further taking a third sample value and a fourth sample value from said data signal (D1) or a further data signal, in response to the third trigger pulse and the fourth trigger pulse, and the analyzing circuit (50) is adapted for determining a second most significant sample value out of the third sample value and the fourth sample value, determining from said edge model a second time difference (Δt2) between the second most significant sample value and a defined transition value and providing a time interval analysis on the base of the second time difference (Δt2) and the first time difference (Δt1).

7. The signal analyzer of any one of the above claims, wherein the control circuit (60) is adapted to generate the trigger pulses (TR1, TR1') relative to the clock signal (CLK), the analyzer thereby being adapted for one of:
receiving the clock signal (CLK) separately from the data signal (D1),
recovering the clock signal (CLK) from the data signal (D1) by means of a clock recovery circuit (24), and
deriving the clock signal (CLK) from an internal clock having a defined frequency relation with respect to the data rate of the data signal (D1).

8. The signal analyzer of any one of the above claims, wherein the sampling circuit (30) comprises a first sample&hold circuit (32) being arranged to receive the first trigger pulse (TR1) at its trigger input and the data signal (D1) at its signal input, and a second sample&hold circuit (32') being arranged to receive the second trigger pulse (TR1') at its trigger input and said data signal (D1) at its signal input.

9. The signal analyzer of any one of the above claims, wherein the defined transition value represents one of: the geometric center with respect to time of the edge model (EM1, EM2), the geometric center with respect to magnitude of the edge model (EM1, EM2) and the most likely transition point.

10. The signal analyzer of any one of the above claims, wherein the edge model (EM1, EM2) represents one of:
a polynomial best fit curve of a measured signal edge (E1, E2, E3, E4),
a section-wise curve composed of one or more linear or polynomial sections,
a curve based on a plurality of measurements of edge curves (E1, E2, E3, E4),

11. The signal analyzer of any one of the above claims, further comprising a filter connected between a data input and each of the sampling circuits (32, 32') for decreasing the slope of the signal transitions (E1, E2, E3, E4).

12. The signal analyzer of any one of the above claims, further comprising
a second sampling circuit (40) adapted for comparing the data signal (D1) with a threshold (VTH) and assigning, in response to a second signal trigger signal (TS1, TS2), bit values (B1, B2, B3) depending on corresponding comparison results, whereby the analyzing circuit (50) is further adapted for providing a signal analysis based on the sample values (A1, A1') received from the first sampling circuit (30) in conjunction with the bit values (B1, B2, B3) received from the second sampling circuit (40).

13. A method of determining time characteristics of a data signal (D1) comprising a sequence of a plurality of bits, the method comprising:
generating a first trigger pulse (TR1) and a second trigger pulse (TR1'), the second trigger pulse (TR1') being delayed with respect to the first trigger pulse (TR1) by a defined time delay,
providing a first sample value (A1) in response to the first trigger pulse (TR1) and a second sample value (A1') in response to the second trigger pulse (TR1') of the data signal (D1),
retrieving an edge model (EM1, EM2) describing an expected signal transition (E1, E2, E3, E4) of the data signal (D1) and being represented as signal magnitude over time within a bit transition region,
determining a first most significant sample value out of the first sample value (A1) and the second sample value (A1'), and
determining from said edge model a first time difference (Δt1) between the most significant sample value (A1, A1') and a defined transition value.

14. A software program or product, preferably stored on a data carrier, for executing the method of the preceding claim, when run on a data processing system such as a computer.

## Patentansprüche

1. Signalanalysator zum Ermitteln des zeitlichen Verlaufs eines Datensignals (D1), das eine Bitfolge einer Vielzahl von Bits aufweist, wobei der Signalanalysator aufweist:
eine Steuerschaltung (60) zum Erzeugen eines ersten Auslöseimpulses (TR1) und eines zweiten Auslöseimpulses (TR1'), wobei der zweite Auslöseimpuls (TR1') um eine definierte Verzögerungszeit in Bezug auf den ersten Auslöseimpuls (TR1) verzögert ist,
eine Abtastschaltung (30) zum Erfassen eines ersten Abtastwertes (A1) und eines zweiten Abtastwertes (A1') vom Datensignal (D1) als Reaktion auf den ersten Auslöseimpuls (TR1) bzw. den zweiten Auslöseimpuls (TR1'), und
**dadurch gekennzeichnet, dass** der Signalanalysator ferner aufweist:
eine Analyseschaltung (50) zum Abrufen eines Flankenmodells (EM1, EM2), das einen erwarteten Signalübergang (E1, E2, E3, E4) des Datensignals (D1) beschreibt und als Signalgröße über die Zeit innerhalb eines Bitübergangsbereichs dargestellt ist, wobei die Analyseschaltung (50) aus dem ersten Abtastwert (A1) und dem zweiten Abtastwert (A1') einen ersten Hauptabtastwert und aus dem Flankenmodell eine erste Zeitdifferenz (Δt1) zwischen dem Hauptabtastwert (A1, A1') und einem definierten Übergangswert ermittelt.

2. Signalanalysator nach Anspruch 1, wobei der erste Hauptabtastwert (A1, A2) als ein Wert ermittelt wird, der einen minimalen Größenabstand zum definierten Übergangswert, vorzugsweise dem Mittelpunkt zwischen einem niedrigen und einem hohen Spannungswert des Datensignals (D1), aufweist.

3. Signalanalysator nach Anspruch 1 oder 2, wobei die Verzögerungszeit auf der Grundlage einer Übergangsdauer des Datensignals (D1) ermittelt wird.

4. Signalanalysator nach irgendeinem der obigen Ansprüche, wobei die Steuerschaltung (60) in der Lage ist, die Verzögerungszeit so festzulegen, dass sie gleich einem Messbereich (TM1, TM2) ist, wobei der Messbereich (TM1, TM2) als Zeitintervall zwischen einem ersten Größenwert (P1), der größer als ein niedriger Spannungswert des Datensignals (D1) ist, und einem zweiten Wert (P2), der kleiner als der hohe Spannungswert des Datensignals (D1) der Signalamplitude ist, gewählt wird.

5. Signalanalysator nach irgendeinem der obigen Ansprüche, bei dem die Steuerschaltung (60) ferner zum Erzeugen eines dritten Auslöseimpulses und eines vierten Auslöseimpulses dient, wobei der dritte Auslöseimpuls und ein vierter Auslöseimpuls um die definierte Verzögerungszeit verzögert werden und wobei der dritte Auslöseimpuls um eine oder um eine Vielzahl von Bitperioden (T, nT) des Datensignals (D1) in Bezug auf den ersten Auslöseimpuls (TR1) verzögert wird.

6. Signalanalysator nach dem vorhergehenden Anspruch, wobei die Abtastschaltung (30) ferner zum Erfassen eines dritten Abtastwertes und eines vierten Abtastwertes vom Datensignal (D1) oder einem weiteren Datensignal als Reaktion auf den dritten Auslöseimpuls und den vierten Auslöseimpuls dient und die Analyseschaltung (50) zum Ermitteln eines zweiten Hauptabtastwertes aus dem dritten Abtastwert und dem vierten Abtastwert dient, wobei der Signalanalysator aus dem Flankenmodell eine zweite Zeitdifferenz (Δt2) zwischen dem zweiten Hauptabtastwert und einem definierten Übergangswert ermittelt und auf der Grundlage der zweiten Zeitdifferenz (Δt2) und der ersten Zeitdifferenz (Δt1) eine Zeitintervallanalyse liefert.

7. Signalanalysator nach irgendeinem der obigen Ansprüche, wobei die Steuerschaltung (60) zum Erzeugen der Auslöseimpulse (TR1, TR1') in Bezug auf das Taktsignal (CLK) dient und der Analysator zu einem der folgenden Schritte dient:
Empfangen des Taktsignals (CLK) getrennt vom Datensignal (D1),
Wiederherstellen des Taktsignals (CLK) aus dem Datensignal (D1) unter Verwendung einer Taktwiederherstellungsschaltung (24), und
Ableiten des Taktsignals (CLK) aus einem internen Takt mit einer definierten Frequenzbeziehung in Bezug auf die Datenrate des Datensignals (D1).

8. Signalanalysator nach irgendeinem der obigen Ansprüche, wobei die Abtastschaltung (30) eine erste Abtast-und-Halteschaltung (32) zum Empfangen des ersten Auslöseimpulses (TR1) an ihrem Auslöseeingang und des Datensignals an ihrem Signaleingang aufweist und wobei eine zweite Abtast-und-Halteschaltung zum Empfangen des zweiten Auslöseimpulses (TR1') an ihrem Auslöseeingang und des Datensignals (D1) an ihrem Signaleingang dient.

9. Signalanalysator nach irgendeinem der obigen Ansprüche, wobei der definierte Übergangswert einen der folgenden Punkte darstellt: den geometrischen Mittelpunkt in Bezug auf die Zeit des Flankenmodells (EM1, EM2), den geometrischen Mittelpunkt in Bezug auf die Größe des Flankenmodells (EM1, EM2) und den wahrscheinlichsten Übergangspunkt.

10. Signalanalysator nach irgendeinem der obigen Ansprüche, wobei das Flankenmodell eine der folgenden Kurven darstellt:
eine durch Polynome geglättete Kurve einer gemessenen Signalflanke (E1, E2, E3, E4),
eine Abschnitte aufweisende Kurve, die aus einem oder mehreren linearen Polynomabschnitten zusammengesetzt ist,
eine Kurve, die auf der Grundlage einer Vielzahl von Messungen von Flankenkurven (E1, E2, E3, E4) erstellt wurde.

11. Signalanalysator nach irgendeinem der obigen Ansprüche, der ferner ein zwischen einen Dateneingang und jede der Abtastschaltungen (32, 32') geschaltetes Filter aufweist, um die Steilheit der Signalübergänge (E1, E2, E3, E4) zu verringern.

12. Signalanalysator nach irgendeinem der obigen Ansprüche, der ferner aufweist:
eine zweite Abtastschaltung (40) zum Vergleichen des Datensignals (D1) mit einem Schwellenwert (VTH) und, als Reaktion auf ein zweites Auslösesignal (TS1, TS2), Zuweisen von Bitwerten (B1, B2, B3) in Abhängigkeit von entsprechenden Vergleichsergebnissen, wobei die Analyserschaltung (50) ferner zum Bereitstellen einer Signalanalyse auf der Grundlage der von der ersten Abtastschaltung (30) empfangenen Abtastwerte (A1, A1') in Verbindung mit den von der zweiten Abtastschaltung (40) empfangenen Bitwerten (B1, B2, B3) dient.

13. Verfahren zum Ermitteln des zeitlichen Verlaufs eines Datensignals (D1), das eine Folge einer Vielzahl von Bits aufweist, wobei das Verfahren die folgenden Schritte aufweist:
Erzeugen eines ersten Auslöseimpulses (TR1) und eines zweiten Auslöseimpulses (TR1'), wobei der zweite Auslöseimpuls (TR1') um eine definierte Verzögerungszeit in Bezug auf den ersten Auslöseimpuls (TR1) verzögert ist,
Bereitstellen eines ersten Abtastwertes (A1) als Reaktion auf den ersten Auslöseimpuls (TR1) und eines zweiten Abtastwertes (A1') als Reaktion auf den zweiten Auslöseimpuls (TR1') des Datensignals (D1),
Abrufen eines Flankenmodells (EM1, EM2), das einen erwarteten Signalübergang (E1, E2, E3, E4) des Datensignals (D1) beschreibt und als Signalgröße über die Zeit innerhalb eines Bitübergangsbereichs dargestellt ist, Ermitteln eines ersten Hauptabtastwertes aus dem ersten Abtastwert (A1) und dem zweiten Abtastwert (A1'), und
Ermitteln einer ersten Zeitdifferenz (Δt1) zwischen dem Hauptabtastwert (A1, A1') und einem definierten Übergangswert.

14. Softwareprogramm oder Softwareprodukt, das vorzugsweise auf einem Datenträger gespeichert ist, zum Durchführen des Verfahrens nach dem vorhergehenden Anspruch, wenn dieses auf einem Datenverarbeitungssystem wie beispielsweise einem Computer ausgeführt wird.

## Revendications

1. Analyseur de signaux pour déterminer des caractéristiques de temporisation d'un signal de données (D1) comprenant une séquence binaire d'une pluralité de bits, l'analyseur de signaux comprenant :
un circuit de commande (60) à même de générer une première impulsion de déclenchement (TR1) et une deuxième impulsion de déclenchement (TR1'), la deuxième impulsion de déclenchement (TR1') étant retardée par rapport à la première impulsion de déclenchement (TR1) d'un retard défini ;
un circuit d'échantillonnage (30) à même d'extraire une première valeur d'échantillonnage (A1) et une deuxième valeur d'échantillonnage (A1') du signal de données (D1) en réponse à la première impulsion de déclenchement (TR1) et à la deuxième impulsion de déclenchement (TR1') respectivement, et
**caractérisé en ce qu'**il comprend en outre :
un circuit d'analyse (50) à même de récupérer un modèle de front (EM1, EM2) décrivant une transition de signal attendue (E1, E2, E3, E4) du signal de données (D1) et étant représenté sous la forme d'une amplitude de signal dans le temps dans les limites d'une zone de transition binaire, de déterminer une première valeur d'échantillonnage de poids fort à partir de la première valeur d'échantillonnage (A1) et de la deuxième valeur d'échantillonnage (A1') et de déterminer à partir dudit modèle de front une première différence temporelle (Δt1) entre la valeur d'échantillonnage de poids fort (A1, A1') et une valeur de transition définie.

2. Analyseur de signaux suivant la revendication 1, dans lequel la première valeur d'échantillonnage de poids fort (A1, A2) est déterminée comme la valeur qui présente une distance de grandeur minimum par rapport à la valeur de transition définie, de préférence le point intermédiaire entre un niveau faible et un niveau élevé du signal de données (D1).

3. Analyseur de signaux suivant la revendication 1 ou 2, dans lequel le retard est déterminé sur la base d'une durée de transition du signal de données (D1).

4. Analyseur de signaux suivant l'une quelconque des revendications précédentes, dans lequel le circuit de commande (60) est à même de déterminer le retard de manière à ce qu'il soit égal à un intervalle de mesure (TM1, TM2), de sorte que l'intervalle de mesure (TM1, TM2) est choisi comme un intervalle de temps entre une première valeur de grandeur (P1) supérieure à un niveau faible du signal de données (D1) et une deuxième valeur (P2) inférieure au niveau élevé du signal de données (D1) de l'amplitude du signal.

5. Analyseur de signaux suivant l'une quelconque des revendications précédentes, dans lequel le circuit de commande (60) est en outre à même de générer une troisième impulsion de déclenchement et une quatrième impulsion de déclenchement, dans lequel la troisième impulsion de déclenchement et la quatrième impulsion de déclenchement sont retardées du retard défini, et dans lequel la troisième impulsion de déclenchement est retardée par rapport à la première impulsion de déclenchement (TR1) d'une ou de plusieurs périodes binaires (T, nT) du signal de données (D1).

6. Analyseur de signaux suivant la revendication précédente, dans lequel le circuit d'échantillonnage (30) est en outre à même d'extraire une troisième valeur d'échantillonnage et une quatrième valeur d'échantillonnage dudit signal de données (D1) ou d'un autre signal de données, en réponse à la troisième impulsion de déclenchement et à la quatrième impulsion de déclenchement, et le circuit d'analyse (50) est à même de déterminer une deuxième valeur d'échantillonnage de poids fort à partir de la troisième valeur d'échantillonnage et de la quatrième valeur d'échantillonnage, de déterminer à partir dudit modèle de front une deuxième différence de temps (Δt2) entre la deuxième valeur d'échantillonnage de poids fort et une valeur de transition définie et de fournir une analyse d'intervalle de temps sur la base de la deuxième différence de temps (Δt2) et de la première différence de temps (Δt1).

7. Analyseur de signaux suivant l'une quelconque des revendications précédentes, dans lequel le circuit de commande (60) est à même de générer les impulsions de déclenchement (TR1, TR1') en fonction du signal d'horloge (CLK), l'analyseur étant de ce fait à même d'effectuer l'une des opérations suivantes :
recevoir le signal d'horloge (CLK) séparément du signal de données (D1) ;
extraire le signal d'horloge (CLK) du signal de données (D1) au moyen d'un circuit d'extraction de signal d'horloge (24), et
dériver le signal d'horloge (CLK) d'une horloge interne ayant une relation en fréquence définie avec le débit de données du signal de données (D1).

8. Analyseur de données suivant l'une quelconque des revendications précédentes, dans lequel le circuit d'échantillonnage (30) comprend un premier circuit échantillonneur bloqueur (32) à même de recevoir la première impulsion de déclenchement (TR1) à son entrée de déclenchement et le signal de données (D1) à son entrée de signal, et un deuxième circuit échantillonneur bloqueur (32') à même de recevoir la deuxième impulsion de déclenchement (TR1') à son entrée de déclenchement et ledit signal de données (D1) à son entrée de signal.

9. Analyseur de signaux suivant l'une quelconque des revendications précédentes, dans lequel la valeur de transition définie représente : le centre géométrique par rapport au temps du modèle de front (EM1, EM2) ou le centre géométrique par rapport à l'amplitude du modèle de front (EM1, EM2) et le point de transition le plus probable.

10. Analyseur de signaux suivant l'une quelconque des revendications précédentes, dans lequel le modèle de front (EM1, EM2) représente :
une courbe du meilleur ajustement polynomiale d'un front de signal mesuré (E1, E2, E3, E4), ou
une courbe à sections composée d'une ou de plusieurs sections linéaires ou polynomiales, ou
une courbe basée sur une pluralité de mesures de courbes de front (E1, E2, E3, E4).

11. Analyseur de signaux suivant l'une quelconque des revendications précédentes, comprenant en outre un filtre connecté entre une entrée de données et chacun des circuits d'échantillonnage (32, 32') pour réduire la pente des transitions de signal (E1, E2, E3, E4).

12. Analyseur de signaux suivant l'une quelconque des revendications précédentes, comprenant en outre :
un deuxième circuit d'échantillonnage (40) à même de comparer le signal de données (D1) à un seuil (VTH) et d'attribuer, en réponse à un deuxième signal de déclenchement (TS1, TS2), des valeurs binaires (B1, B2, B3) en fonction de résultats de comparaison correspondants, de sorte que le circuit d'analyse (50) est en outre à même de fournir une analyse de signaux sur la base des valeurs d'échantillonnage (A1, A1') reçues du premier circuit d'échantillonnage (30) en conjonction avec les valeurs binaires (B1, B2, B3) reçues du deuxième circuit d'échantillonnage (40).

13. Procédé de détermination de caractéristiques de temporisation d'un signal de données (D1) comprenant une séquence d'une pluralité de bits, le procédé comprenant :
la génération d'une première impulsion de déclenchement (TR1) et d'une deuxième impulsion de déclenchement (TR1'), la deuxième impulsion de déclenchement (TR1') étant retardée par rapport à la première impulsion de déclenchement (TR1) d'un retard défini ;
la fourniture d'une première valeur d'échantillonnage (A1) en réponse à la première impulsion de déclenchement (TR1) et d'une deuxième valeur d'échantillonnage (A1') en réponse à la deuxième impulsion de déclenchement (TR1') du signal de données (D1),
la récupération d'un modèle de front (EM1, EM2) décrivant une transition de signal attendue (E1, E2, E3, E4) du signal de données (D1) et étant représenté sous la forme d'une amplitude de signal dans le temps dans les limites d'une zone de transition binaire ;
la détermination d'une première valeur d'échantillonnage de poids fort à partir de la première valeur d'échantillonnage (A1) et de la deuxième valeur d'échantillonnage (A1'), et
la détermination à partir dudit modèle de front d'une première différence temporelle (Δt1) entre la valeur d'échantillonnage de poids fort (A1, A1') et une valeur de transition définie.

14. Programme ou produit logiciel, de préférence stocké sur un support de données, pour exécuter le procédé suivant la revendication précédente, lorsqu'il est exécuté sur un système de traitement de données comme un ordinateur.
